**Europäisches Patentamt**

**European Patent Office**

**Office européen des brevets**

(19)

(11) Veröffentlichungsnummer: **0 020 928**
**B1**

(12)
# EUROPÄISCHE PATENTSCHRIFT

(45) Veröffentlichungstag der Patentschrift:
20.07.83

(21) Anmeldenummer: **80102232.8**

(22) Anmeldetag: **25.04.80**

(51) Int. Cl.³: **G 11 C 11/24**, G 11 C 11/34, G 11 C 11/40

(54) **Elektrische Speicheranordnung und Verfahren zu ihrem Betrieb.**

(30) Priorität: **30.06.79 DE 2926514**

(43) Veröffentlichungstag der Anmeldung:
**07.01.81 Patentblatt 81/1**

(45) Bekanntmachung des Hinweises auf die Patenterteilung:
**20.07.83 Patentblatt 83/29**

(84) Benannte Vertragsstaaten:
**DE FR GB NL SE**

(56) Entgegenhaltungen:
**DE-A-2 612 666**
**US-A-3 765 002**

**IBM TECHNICAL DISCLOSURE BULLETIN, Band 15, Nr. 5, Oktober 1972, Seiten 1720–1721 New York, USA H. KLEPP et al.: «Circuit useable as storage cell or detector-amplifier cell»**

(73) Patentinhaber: **International Business Machines Corporation, Old Orchard Road, Armonk, N.Y. 10504 (US)**

(72) Erfinder: **Heimeier, Helmut, Dr., Auf der Breite 23, D-7033 Herrenberg 4 (DE)**
Erfinder: **Klein, Wilfried, Ulmenstrasse 86, D-7031 Holzgerlingen (DE)**
Erfinder: **Najmann, Knut, Sonnenhalde 15, D-7031 Gärtringen (DE)**
Erfinder: **Wernicke, Friedrich, Herdlauchring 6, D-7036 Schönaich (DE)**

(74) Vertreter: **Mönig, Anton, Dipl.-Ing., Schönaicher Strasse 220, D-7030 Böblingen (DE)**

## Elektrische Speicheranordnung und Verfahren zu ihrem Betrieb

Die Erfindung bezieht sich auf elektrische Speicheranordnungen, die Speicherzellen und zugeordnete Leseschaltkreise für die Ausgabe der Speicherinformation enthalten. Als Anwendungsgebiet der Erfindung kommen in erster Linie integrierte Halbleiterspeicher für Datenverarbeitungsanlagen in Betracht, bei denen u. a. einer möglichst kurzen effektiven Zugriffszeit zu den gespeicherten Daten eine hohe Bedeutung zukommt.

Bisher war man bei der Entwicklung neuer bzw. der Auswahl verfügbarer Speicheranordnungen stets bestrebt, bezüglich der Speicherzellen und Leseschaltkreise eine möglichst gute Symmetrie und damit gleiche Zugriffszeiten für die unterscheidbaren Speicherzustände «0» und «1» zu gewährleisten. Als Beispiel für dieses aus dem Stand der Technik deutlich werdende dauernde Bestreben, zumindest systematische, durch den Aufbau der Speicheranordnung bedingte planmässige Unsymmetrien auszuschliessen bzw. auszugleichen, seien lediglich die US-Patentschrift 4 122 546 und die Veröffentlichung im IBM Technical Disclosure Bulletin Vol. 17, No. 5, Oktober 1974, Seite 1355 stellvertretend genannt.

Allgemein gilt, wo sich derartige in unterschiedlichen Lesegeschwindigkeiten bzw. Zugriffszeiten für die unterscheidbaren Speicherzustände resultierenden systematischen Unsymmetrien im Bereich der Speicherzellen nicht ausschliessen liessen, wurden aufwendige Kompensationsmassnahmen erforderlich, um letztlich die für erforderlich gehaltenen symmetrischen Betriebseigenschaften zu erreichen. Stets aber musste als unmittelbare Folge unterschiedlich langer Zugriffszeiten je nach dem gerade gespeicherten logischen Zustand in Kauf genommen werden, dass die Weiterverarbeitung der ausgelesenen Speicherinformationen nur auf der Basis der längeren Zugriffszeit erfolgen konnte.

Eine Möglichkeit der Verkürzung der Zugriffszeiten durch Verkürzung der längeren Lesezeit für einen der unterscheidbaren Speicherzustände ist in der US-A-3 765 002 beschrieben. Dort wird zur Verringerung der verhältnismässig längeren Entladezeit beim Auslesen eines der unterscheidbaren Speicherzustände ein zusätzlicher Hilfsentladekreis vorgesehen, der während des Entladevorganges bei Erreichen eines bestimmten Schwellenpotentials aktiviert wird. Das zweckentsprechende Funktionieren des zusätzlichen Hilfsentladekreises setzt voraus, dass vor dem Lesen die Leseleitung auf ein Potential vorgespannt wird, das dem schneller auslesbaren Speicherzustand entspricht.

Es ist die Aufgabe der Erfindung, für die Zusammenstellung von Speicherzellen und zugeordneten Leseschaltkreisen in einer Speicheranordnung Massnahmen anzugeben, mit denen die resultierenden Eigenschaften im Lesebetrieb im Sinne einer möglichst kurzen effektiven Zugriffszeit verbessert werden können. Die diese Aufgabe lösende Erfindung ist in den Patentansprüchen gekennzeichnet, Zusammengefasst können danach Speicherzellen zugelassen bzw. planmässig so ausgelegt werden, dass sie hinsichtlich der unterscheidbaren Speicherzustände, z.B. im Falle eines digitalen Speichers für die logische «0» und «1», systematisch unterschiedlich lange interne Zugriffszeiten aufweisen. Dennoch kann die Weiterverarbeitung der ausgelesenen Speicherinformationen auf der Basis der kürzeren internen Zugriffszeit erfolgen, wenn in Verbindung mit derartigen Speicherzellen ein entsprechend gegenläufig voreingestellter Leseverstärker vorgesehen wird. Bei Speicherzellen, bei denen z.B. der Speicherzustand «0» schneller als der Speicherzustand «1» erscheint, bedeutet das beispielsweise, dass der Leseverstärker zu Beginn eines Lesevorganges auf den langsameren Ausgangszustand «1» voreingestellt wird. Ist der ausgelesene Speicherzustand eine (langsame) «1», ist dieser Ausgangszustand bereits vorhanden und erfordert keine weitere Einstellzeit der Ausgabeschaltung. Eine Umschaltung des Ausgangszustandes ist lediglich im Falle einer auszulesenden (schnellen) «0» erforderlich, die jedoch voraussetzungsgemäss früher am Ausgang der Speicherzelle zur Verfügung steht. Die effektive Zugriffszeit wird damit nicht mehr durch die längere interne Zugriffszeit bestimmt.

Die Erfindung wird im folgenden anhand von lediglich einen Ausführungsweg darstellenden Zeichnungen näher erläutert.

Es zeigen:

Fig. 1 ein teilweise schematisches Schaltbild einer Speicheranordnung mit einer Speicherzelle und einem zugeordneten Leseschaltkreis,

Fig. 2 eine Draufsicht auf eine an sich bekannte integrierte Halbleiterspeicherzelle mit systematischer Unsymmetrie hinsichtlich der Zugriffszeiten und

Fig. 3 und 4 Zeitdiagramme zur Erläuterung der Betriebsweise von Fig. 1 bei einem Lesevorgang für eine (schnelle) «0» (Fig. 3) und für eine (langsame) «1» (Fig. 4).

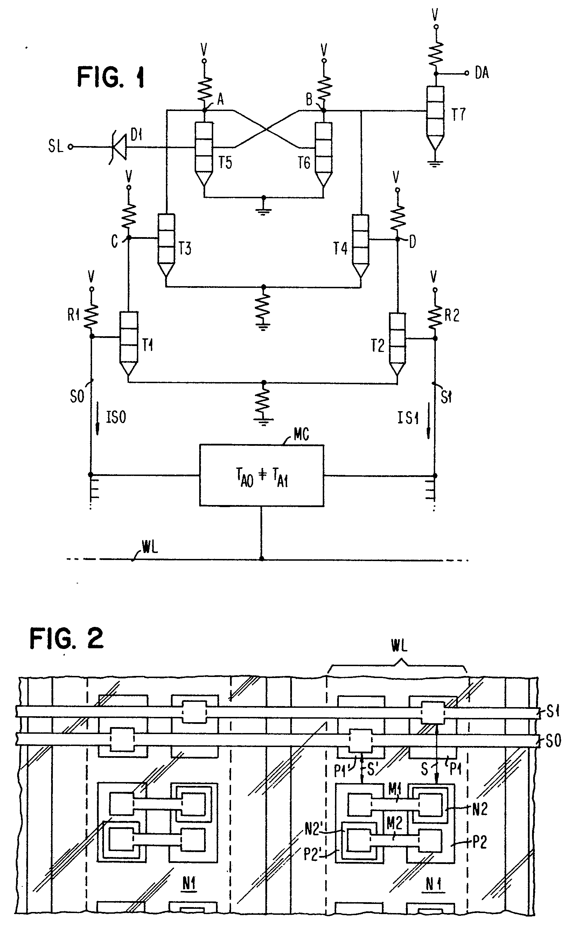

Als ein Ausführungsbeispiel der Erfindung ist in Fig. 1 schematisch eine Speicherzelle MC zusammen mit einer möglichen Ausführungsform eines zugehörigen Leseschaltkreises dargestellt. Da sich die Erfindung, wie bereits erwähnt, auf die Verbindung Speicherzelle/Leseschaltkreis bezieht, sind weitere im Rahmen einer vollständigen Speicheranordnung vorzusehende Schaltkreise für die Auswahl-, Schreibeinrichtungen usw. in Fig. 1 nicht berücksichtigt. Insoweit können konventionelle Schaltkreise eingesetzt werden, auf die im Rahmen dieser Erfindung nicht besonders eingegangen zu werden braucht. Bezüglich der in Fig. 1 mit MC bezeichneten Speicherzelle ist angenommen, dass sie unterschiedlich lange interne Zugriffszeiten hinsichtlich der unterscheidbaren Speicherzustände aufweist. Für den in der Praxis am häufigsten vorkommenden Fall, dass es sich um einen Digitalspeicher handelt, sei im Rahmen dieses Ausführungsbeispiels weiter angenommen, dass die bei einem Lesevorgang am Ausgang einer selektierten Speicherzelle wiedergegebene Speicherinformation derart unsymmetrisch ist, dass der logische «0»-Zustand früher erscheint als der logische «1»-Zustand.

Als Beispiel für eine derartig unsymmetrische Speicherzelle ist in Fig. 2 ein Ausschnitt aus einem Layout für einen MTL- bzw. I²L-Halbleiterspeicher gezeigt, aus dem der Aufbau zweier solcher Speicherzellen deutlich wird. Es handelt sich dabei um eine bekannte Speicherzelle, die in der DE-Offenlegungsschrift 2 612 666 der Anmelderin (internes Zeichen GE 976 005) näher beschrieben ist. In vereinfachter Form lässt sich sagen, dass jede Speicherzelle zwei über die Leiterzüge M1 und M2 kreuzgekoppelte vertikal ausgebildete Transistoren N1/P2/N2 und N1/P2'/N2' enthält. Jedem dieser Transistoren ist auf der gleichen Seite ein Injektionsgebiet P1 bzw. P1' zur Bildung einer lateralen Transistorstruktur P1/N1/P2 bzw. P1'/N1/P2' vorgelagert. Über diese auf der gleichen Seite der Speicherzelle angeordneten Injektionsgebiete P1 und P1' verlaufen die Abfühlleitungen S1 und S0. Dabei weist die Abfühlleitung S1 mit dem Injektionsgebiet P1 einen Kontakt auf und entsprechend die Abfühlleitung S0 mit dem Injektionsgebiet P1'. Durch die bei diesem Layout vorliegende unsymmetrische Anordnung der Kontakte ergeben sich die in Fig. 2 mit S bzw. S' bezeichneten unterschiedlichen Abstände. Aufgrund der daraus folgenden unsymmetrischen lateralen Widerstände erscheint das Abfühlsignal für den einen logischen Zustand systematisch später als für den anderen. Selbstverständlich sind auch andere Ausführungen von Speicherzellen möglich, bei denen planmässig unterschiedliche interne Zugriffszeiten vorliegen.

Im Rahmen der folgenden Beschreibung wird überdies weiterhin deutlich werden, dass bei Anwendung der Erfindung derartig unsymmetrische Zellen nicht nur zugelassen werden können, sondern dass es in manchen Fällen ausgesprochen vorteilhaft sein kann, solche Speicherzellen bewusst unsymmetrisch auszulegen und dennoch auf der Grundlage der kürzeren internen Zugriffszeit die Weiterverarbeitung der ausgelesenen Speicherinformation vorzunehmen. Dies ist besonders bei solchen Speichern von Interesse, für die – wie bei den oben bereits erwähnten MTL-Speichern – gilt, dass die Summe der internen Zugriffszeiten für «0» und «1» bei einem gegebenen Herstellungsprozess und vereinbarten Mindestabständen usw. innerhalb eines gewissen Rahmens konstant ist. Statt wie bisher den Schwerpunkt auf die Erzielung möglichst gleicher interner Zugriffszeiten zu legen, wird gezeigt werden, dass es zusammen mit den weiteren noch anzugebenden Massnahmen sehr vorteilhaft sein kann, die interne Zugriffszeit zu einer Speicherinformation des einen logischen Zustands, z. B. «0»-Zustands, auf Kosten der Zugriffszeit zum «1»-Zustand zu verringern.

Zurückkommend auf Fig. 1 ist mit der Speicherzelle MC über die beiden Abfühlleitungen S0 und S1 ein Leseschaltkreis gekoppelt, der im gezeigten Beispiel einen zweistufigen Differenzverstärker mit den Transistoren T1 und T4, einen Abfühl-Verriegelungskreis in Form des Flipflops mit den Transistoren T5 und T6 sowie eine Ausgangstreiberstufe mit dem Transistor T7 enthält. Mit A, B, C und D sind einige Schaltungsknoten bezeichnet, deren zeitlicher Potentialverlauf später zur Erläuterung der Betriebsweise der Erfindung herangezogen wird. Der Abfühl-Verriegelungskreis ist mit einem über eine Schottky-Diode D1 geführten Steuereingang SL ausgestattet, wodurch das Flipflop zu Beginn eines Lesevorgangs auf einen vorbestimmten Zustand eingestellt bzw. gesetzt werden kann. Das aus der Speicherzelle ausgelesene Signal steht schliesslich in verstärkter Form am Datenausgang DA für die Weiterverarbeitung zur Verfügung.

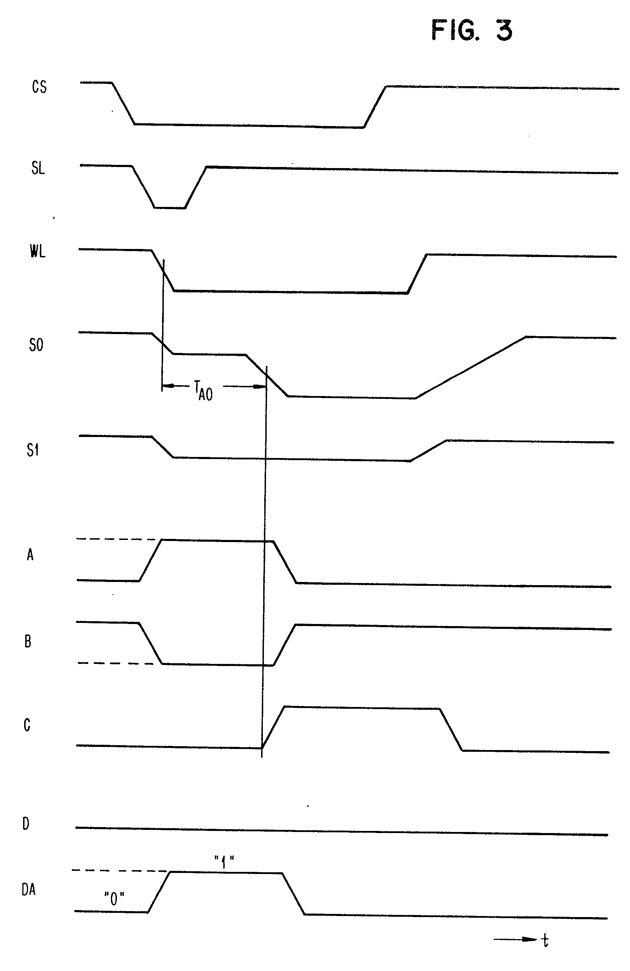

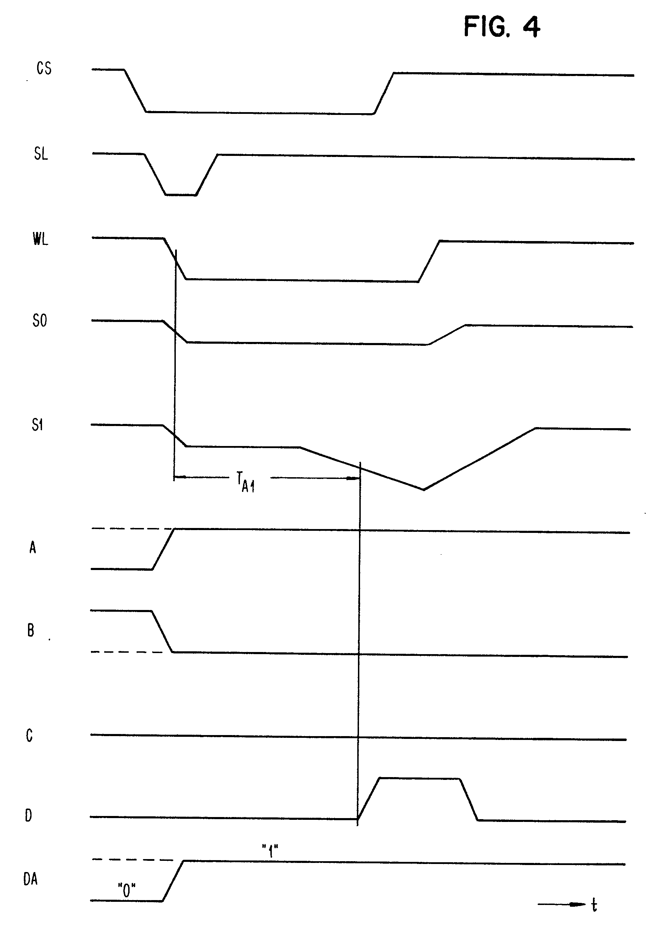

Zusammen mit den Zeitdiagrammen der Fig. 3 und 4 soll im folgenden auf die Betriebsweise der Erfindung näher eingegangen werden, wobei insbesondere die Lesevorgänge für die beiden unterscheidbaren Speicherzustände, nämlich eine schnelle «0» und eine langsame «1», näher beschrieben werden.

Im Ruhezustand ist die Wortleitung WL nicht selektiert, was einem oberen Spannungspegel auf der Wortleitung entsprechen möge. An den Abfühlleitungen S0 und S1 fliessen keine Ströme IS0 und IS1. Dadurch sind die Steuereingänge der Transistoren T1 und T2 der ersten Differenzverstärkerstufe über die Widerstände R1 und R2 aus der positiven Versorgungsspannungsquelle V im Leitzustand vorgespannt. Aufgrund des Stromflusses durch die Transistoren T1 und T2 sind die Potentiale der Schaltungsknoten C und D am Eingang der zweiten Transistoren T3 und T4 gesperrt sind. Bei gesperrten Transistoren T3 und T4 wird der Abfühl-Verriegelungskreis nicht beeinflusst und kann somit entsprechend seiner Aufgabe die im vorangegangenen Lesezyklus abgeführte Speicherinformation speichern.

Für die Beschreibung der Arbeitsweise im selektierten Zustand sei zunächst angenommen, dass eine mit relativ kurzer interner Zugriffszeit verfügbare «0» ausgelesen werden soll. Die zugehörigen Potentialverhältnisse sind in Fig. 3 dargestellt. Über ein üblicherweise vorgesehenes Chip-Auswahlsignal CS wird die nichtdargestellte Peripherie des Chips selektiert und letztlich auch das Einschalten der Wortleitung WL (Absenken des WL-Potentials) vorbereitet. Ausserdem wird im Falle eines Lesevorgangs ein kurzes Setzsignal SL für den Abfühl-Verriegelungskreis erzeugt. Dieses Signal SL zieht über die Schottky-Diode D1 den Schaltungsknoten B des Flipflops nach unten. Sofern das Flipflop nicht schon vorher in seinem «1»-Zustand (Knoten B entladen) war, kippt es durch den Setzimpuls in diesem Zustand und am Ausgang DA tritt der obere Spannungspegel entsprechend dem «1»-Zustand auf. Über die Wortleitung WL wird die zu lesende Speicherzelle selektiert und liefert nach einer internen Zugriffszeit

$T_{AO}$ ein entsprechendes Lesesignal auf der S0-Leitung. Diese interne Zugriffszeit $T_{AO}$ reicht dabei vom Absenken des WL-Potentials, dem das S0-Potential zunächst folgt, bis zur vom jeweiligen Speicherzustand abhängigen weiteren Potentialabsenkung auf der S0- (oder S1-) Leitung. Für die zeichnerische Verdeutlichung dieser Vorgänge sind jeweils die 50%-Werte der Impulsflanken

herangezogen worden. Beim Lesen eines (schnellen) «0»-Zustandes stellt sich somit auf der S0-Leitung eine relativ zur S1-Leitung tiefere Potentialabsenkung ein. Dieses Signal wird über die beiden Differenzverstärker mit den Transistoren T1 bis T4 verstärkt, wobei von den beiden vorher leitenden Transistoren T1 und T2 der Transistor T1 gesperrt wird und von den beiden vorher gesperrten Transistoren T3 und T4 in der nächsten Differenzverstärkerstufe T3 leitend wird. Infolge des nunmehr leitenden Transistors T3 wird das Potential des Schaltungsknotens A abgesenkt, so dass das Flipflop in den gegenüber dem Ruhezustand entgegengesetzten Zustand kippt und am Ausgang DA der untere Spannungspegel entsprechend einer «0» erscheint.

Um zu verhindern, dass während der Selektion der Wortleitung etwaige kleine Asymmetrien den Abfühl-Verriegelungskreis versehentlich in den «0»-Zustand umschalten, kann es vorteilhaft sein, die erste Differenzverstärkerstufe mit den Transistoren T1 und T2 etwas unempfindlicher zu machen. Das kann beispielsweise dadurch geschehen, dass die Emitterfläche des Transistors T1 etwas grösser ausgebildet wird als für den Transistor T2.

Anhand von Fig. 4 ist der Lesevorgang für eine (langsame) «1» gezeigt. Bezüglich der zu Beginn des Lesevorgangs vorliegenden Verhältnisse besteht gegenüber Fig. 3 kein Unterschied. Der Abfühl-Verriegelungskreis wurde, wie bereits beschrieben, kurz nach Beginn des Lesezyklus auf den mit der längeren internen Zugriffszeit verbundenen «1»-Zustand voreingestellt. m Ausgang DA liegt also unabhängig von dem vorher gelesenen Speicherzustand bereits eine «1» vor. Auf die Selektion der Wortleitung WL hin sinkt in diesem Fall erst nach einer relativ langen internen Zugriffszeit $T_{A1}$ das Potential der S1-Leitung endgültig ab und schaltet den Transistor T2 aus. Dadurch kann das Potential am Schaltungsknoten D ansteigen und der Transistor T4 leitend werden. Der Schaltungsknoten B des Verriegelungskreises ist jedoch bereits zu Anfang des Lesevorgangs entladen worden. Damit spielt der Zeitpunkt, zu dem der Transistor T4 durch das langsame Lesesignal eingeschaltet wird, für die effektive Zugriffszeit hinsichtlich des Datenausganges DA keine Rolle mehr. Mit anderen Worten, es geht im Falle eines auszulesenden «1»-Zustandes, dessen relativ lange interne Zugriffszeit nicht in die externen Zugriffszeiten ein, weil in diesem Fall nur noch der den Ausgang nicht beeinflussende Schaltungsknoten B umgeladen werden muss. Das Umladen dieses Knotens braucht jedoch lediglich bis zum vollständigen Abschluss des Lesezyklus beendet zu sein.

Soweit zur Verdeutlichung der Erfindung das oben beschriebene Ausführungsbeispiel herangezogen wurde, ist noch einmal festzuhalten, dass im Rahmen der Erfindung sowohl hinsichtlich der jeweiligen Speicherzellen als auch der Leseschaltkreise vielfältige Ausführungsmöglichkeiten bestehen. So ist die Erfindung grundsätzlich nicht auf Speicherzellen mit lediglich zwei unterscheidbaren Zuständen beschränkt. Ein Gewinn an effektiver Zugriffszeit lässt sich gleichermassen auch bei mehr als zwei unterscheidbaren Speicherzuständen erzielen, von denen mindestens einer eine relativ längere interne Zugriffszeit aufweist. Für die Ausführung des zugehörigen Leseschaltkreises wäre auch in diesem Fall lediglich die Massnahme zu treffen, dass zu Beginn des Lesevorgangs der Ausgangszustand mit der längeren internen Zugriffszeit voreingestellt wird. Die Erfindung ist ferner nicht beschränkt auf Speicherzellen einer bestimmten Technologie, z.B. mit Bipolar- oder Feldeffekttransistoren; es können auch andere als Halbleiterspeicheranordnungen in der beschriebenen Weise zusammengestellt werden. Dabei spielt es keine Rolle, ob es sich um Schreib-/Lesespeicher, Festwertspeicher oder dergleichen handelt, da die Erfindung die Verbesserung der Lesebetriebseigenschaften in der eingangs erwähnten Weise betrifft.

Auch bezüglich der in Frage kommenden Leseschaltkreise ist die Erfindung nicht auf die im obigen Ausführungsbeispiel angenommenen Verhältnisse beschränkt. Ein Leseschaltkreis muss nicht in jedem Fall einen Verriegelungskreis und/oder einen (gar zweistufigen) Differenzverstärker aufweisen. Bei Speicherzellen mit einem sehr starken Lesesignal könnte auch direkt eine Ausgangsstufe angesteuert werden. In diesem Fall wären die Massnahmen zur Voreinstellung eines bestimmten Ausgangszustandes innerhalb der Ausgangsstufe vorzusehen.

Ferner müsste eine solche Ausgangstreiberstufe, sofern sie überhaupt neben einem Differenzverstärker und/oder Verriegelungskreis nötig wäre, nicht in jedem Fall als Inverter wie im Ausführungsbeispiel ausgebildet sein.

Schliesslich kann die Vorgehensweise nach der Erfindung auch dadurch angezeigt sein, dass aus bestimmten Gründen von einem hinsichtlich der Lesegeschwindigkeiten für die unterschiedbaren Speicherzustände unsymmetrischen Leseschaltkreis auszugehen wäre. Auch in diesem Fall könnte die extern verfügbare Zugriffszeit zu den Daten durch bewusst gegenläufig unsymmetrische Auslegung der für den Einsatz in Aussicht genommenen Speicherzellen auf der Basis des Lesesignals mit der höheren Lesegeschwindigkeit verbessert werden.

Somit ist gezeigt, dass eine bisher in der Regel als nachteilig angesehene Unsymmetrie hinsichtlich der internen Zugriffszeiten bzw. Lesegeschwindigkeiten für die unterscheidbaren Speicherzustände bei entsprechender Zusammenstellung der die Speicheranordnung bildenden Speicherzellen und Leseschaltkreise in einen Vorteil bezüglich der nach aussen hin massgeblichen Betriebseigenschaften umgewandelt werden kann.

**Patentansprüche**

1. Speicheranordnung enthaltend Speicherzellen und zugeordnete Leseschaltkreise für die Ausgabe der Speicherinformation, dadurch gekennzeichnet, dass hinsichtlich der internen Zugriffszeiten für die unterscheidbaren Speicherzustände systematisch unsymmetrische Speicherzellen vorgesehen sind, dass in den mit den Speicherzellen gekoppelten Leseschaltkreisen Schaltungsmassnahmen getroffen sind, wodurch der Ausgangszustand jeweils zu Beginn eines Lesevorganges unabhängig vom vorhergehenden Zustand auf den mit der längeren Zugriffszeit verbundenen Speicherzustand voreingestellt wird, und dass eine Umschaltung des Ausgangszustandes eines Leseschaltkreises lediglich beim Zugriff zu einem mit der kürzeren Zugriffszeit verbundenen Speicherzustand erfolgt.

2. Speicheranordnung nach Anspruch 1, dadurch gekennzeichnet, dass sie für zwei unterscheidbare Speicher- und Ausgangszustände ausgeführt ist.

3. Speicheranordnung nach einem der vorhergehenden Ansprüche, gekennzeichnet durch Speicherzellen eines gattungsmässigen Typs, für den gilt, dass die Summe der internen Zugriffszeiten für jeden der unterscheidbaren Speicherzustände annähernd gleich ist.

4. Speicheranordnung nach einem der vorhergehenden Ansprüche, gekennzeichnet durch in MTL- bzw. I²L-Technik aufgebaute Speicherzellen (Fig. 2), die mit auf der gleichen Seite der Speicherzelle angeordneten Injektionsgebieten (P1, P1') mit daran angeschlossenen Abfühlleitungen (S1, S0) ausgeführt sind.

5. Speicheranordnung nach einem der vorhergehenden Ansprüche, gekennzeichnet durch einen zu Beginn eines Lesevorgangs auf einen vorbestimmten Zustand einstellbaren Verriegelungskreis.

6. Speicheranordnung nach einem der vorhergehenden Ansprüche, gekennzeichnet durch einen mindestens einen Differenzverstärker (T1, T2; T3, T4) enthaltenden Leseschaltkreis, dessen Steuereingänge über ein eine Differenzspannung lieferndes Paar von Abfühlleitungen (S0, S1) mit den Speicherzellen (MC) und dessen Ausgänge mit einem als Verriegelungskreis dienenden Flipflop (T5, T6) gekoppelt sind, wobei an mindestens eine Seite des Flipflops eine Ausgangstreiberstufe (T7) angeschlossen ist.

7. Speicheranordnung nach einem der vorhergehenden Ansprüche, dadurch gekennzeichnet, dass an dem mit der Ausgangstreiberstufe (T7) gekoppelten Schaltungsknoten (B) des Flipflops (T5, T6) ein Setz-Eingang (SL) zum Voreinstellen des Flipflop- bzw. Ausgangszustandes (an DA) auf den mit der längeren Zugriffszeit verbundenen Speicherzustand angeordnet ist.

8. Verfahren zum Betrieb einer Speicheranordnung nach mindestens einem der vorhergehenden Ansprüche, dadurch gekennzeichnet, dass zum Auslesen der Speicherinformation aus hinsichtlich der Zugriffszeiten für die unterscheidbaren Speicherzustände systematisch unsymmetrischen Speicherzellen der Ausgangszustand eines zugeordneten Leseschaltkreises jeweils zu Beginn eines Lesevorganges unabhängig vom vorhergehenden Ausgangszustand auf den mit der längeren Zugriffszeit verbundenen Speicherzustand voreingestellt wird, und dass eine Umschaltung des Ausgangszustandes des Leseschaltkreises lediglich beim Zugriff zu einem mit der kürzeren Zugriffszeit verbundenen Speicherzustand durchgeführt wird.

**Claims**

1. Storage arrangement containing memory cells and associated read circuits for the output of the memory information, characterized in that with respect to the internal access times for the distinguishable memory states systematically asymmetrical memory cells are provided, that as a consequence of switching means in the read circuits coupled to the memory cells the output state is pre-set at the beginning of a read operation to the memory state having the longer access time, independently of the preceding state, and that the output state of a read circuit is switched only upon the access to a memory state with the shorter access time.

2. Storage arrangement as claimed in claim 1, characterized in that it is designed for two distinguishable storage and output states.

3. Storage arrangement as claimed in one of the preceding claims, characterized by storage cells of the particular species for which the sum of the internal access times for each of the distinguishable storage states is approximately the same.

4. Storage arrangement as claimed in one of the preceding claims, characterized by memory cells (Fig. 2) in MTL- or I²L-technique that are designed with injection zones (P1, P1') with sense lines (S1, S0) connected thereto, arranged on the same side of the storage cell.

5. Storage arrangement as claimed in one of the preceding claims, characterized by a latch circuit which can be set to a predetermined state at the beginning of a read operation.

6. Storage arrangement as claimed in one of the preceding claims, characterized by a read circuit containing at least one differential amplifier (T1, T2; T3, T4) whose control inputs are coupled to the memory cells (MC) via a pair of sense lines (S0, S1) supplying a differential voltage, and whose outputs are coupled to a flipflop (T5, T6) acting as a latch circuit, an output driver stage (T7) being connected to at least one side of the flipflop.

7. Storage arrangement as claimed in one of the preceding claims, characterized in that at the flipflop (T5, T6) circuit node (B) coupled to the output driver stage (T7) a set input (SL) is arranged for pre-setting the flipflop or output state (at DA) to the memory state having the longer access time.

8. Method of operating a storage arrangement as claimed in at least one of the preceding claims, characterized in that for reading out the storage date from memory cells that are systematically asymmetric with respect to the access times for the distinguishable memory states at the beginning of a read operation, independently of the preceding output state, the output state of an associated read circuit is pre-set to the memory state having the longer access time, and that the output state of the read circuit is switched only upon the access to a memory state having the shorter access time.

**Revendications**

1. Système de mémoire comportant des cellules de mémoire et des circuits de lecture associés pour la sortie des informations stockées, caractérisé en ce que les cellules de mémoire sont systématiquement asymétriques quant aux délais d'accès internes pour les états de mémoire différenciables, en ce que les circuits de lecture associés aux cellules de mémoire comportent des moyens de commutation permettant de fixer au préalable l'état de sortie avant le début de chaque processus de lecture, indépendamment de l'état précédent, pour adopter l'état de mémoire lié au délai d'accès le plus long, et en ce que le fait d'accéder à un état de mémoire lié au délai d'accès le plus court a pour seul effet de provoquer une commutation de l'état de sortie d'un cricuit de lecture.

2. Système de mémoire selon la revendication 1, caractérisé en ce qu'il est réalisé pour deux états différenciables de mémoire et de sortie.

3. Système de mémoire conforme à l'une des revendications 1 ou 2, caractérisé en ce qu'il comporte des cellules de mémoire d'un type particulier pour lequel la somme des délais d'accès internes est sensiblement la même pour chacun des états de mémoire différenciables.

4. Systèm1 de mémoire selon l'une des revendications 1 à 3, caractérisé en ce qu'il comporte des cellules de mémoire réalisées en technologie MTL ou I²L (fig. 2), ces cellules de mémoire étant pourvues de zones d'injection (P1, P1') disposées du même côté de chaque cellule de mémoire et raccordées à des lignes de lecture (S1, S0).

5. Système de mémoire selon l'une des revendications 1 à 4 caractérisé en ce qu'il comporte un circuit de verrouillage pouvant être ajusté à un état prédéterminé au début d'un processus de lecture.

6. Système de mémoire selon l'une des revendications 1 à 5, caractérisé en ce qu'il comporte un circuit de lecture ayant au moins un amplificateur différentiel (T1, T2; T3, T4), les entrées de commande de circuit étant reliées aux cellules de mémoire (MC) par l'intermédiaire d'une paire de lignes de lecture (S0, S1) fournissant une tension différentielle, et les sorties de ce circuit étant reliées à une bascule (T5, T6) jouant le rôle de circuit de verrouillage, un étage d'excitation de sortie (T7) étant en outre relié à au moins un côté de la bascule (flip-flop).

7. Système de mémoire selon l'une des revendications 1 à 6, caractérisé en ce qu'il comporte une entrée de commande d'état (SL), disposée à l'endroit du noeud de commande (B) de la bascule (T5, T6) associé à l'étage d'excitation de sortie (T7), pour assurer le réglage préalable de la bascule ou de l'état de sortie en adoptant l'état de mémoire lié au délai d'accès le plus long.

8. Procédé d'exploitation d'un système de mémoire conformément à l'une des revendications 1 à 7, caractérisé en ce que, pour lire les informations stockées dans des cellules de mémoire systématiquement asymétriques quant aux délais d'accès aux états de mémoire différenciables, on règle au préalable l'état de sortie d'un circuit de lecture associé, au début de chaque processus de lecture, et indépendamment de l'état de sortie précédent, pour adopter l'état de mémoire lié au délai d'accès le plus long, et en ce que le fait d'accéder à un état de mémoire lié au délai d'accès le plus court a pour seul effet de provoquer une permutation de l'état de sortie du circuit de lecture.

# FIG. 1

# FIG. 2

# FIG. 3

# FIG. 4